**Europäisches Patentamt**

**European Patent Office**

**Office européen des brevets**

(11) Veröffentlichungsnummer : **0 433 263 A2**

# (12) EUROPÄISCHE PATENTANMELDUNG

(21) Anmeldenummer : 90890285.1

(22) Anmeldetag : 19.10.90

(51) Int. Cl.⁵ : **G03F 7/20**

(30) Priorität : 13.12.89 AT 2831/89

(43) Veröffentlichungstag der Anmeldung :
**19.06.91 Patentblatt 91/25**

(84) Benannte Vertragsstaaten :
**AT BE CH DE ES FR GB IT LI LU NL SE**

(71) Anmelder : Thallner, Erich, Dipl.-Ing.
**Bubing 71**
**A-4780 Schärding (AT)**

(72) Erfinder : Thallner, Erich, Dipl.-Ing.
**Bubing 71**
**A-4780 Schärding (AT)**

(74) Vertreter : Hübscher, Heiner, Dipl.-Ing. et al
**Spittelwiese 7**
**A-4020 Linz (AT)**

(54) **Verfahren und Vorrichtung zur Belichtung lichtempfindlichgemachter Substrate, insbesondere Halbleitersubstrate.**

(57)   Bei dem Verfahren wird eine ein Belichtungsmuster bestimmende Schablone (17) über eine Beleuchtungseinrichtung (8-10) beleuchtet und das Belichtungsmuster wird über eine Projektionsoptik (6) in nacheinander projizierten Bildteilen auf ein lichtempfindlich gemachtes Substrat (19) übertragen. Es wird eine Projektionsoptik (6) verwendet, die nur einen kleinen, nahezu punktförmigen Bildausschnitt der Schablone (17) erfaßt und auf die zugeordnete Stelle des Substrates (19) überträgt, wobei die vollständige Belichtung des Substrates (19) unter Erzeugung einer eine zeilenweise Abtastung ergebenden Relativbewegung zwischen der Projektionsoptik (6), der Schablone (17) und dem Substrat (19) vorgenommen wird. Eine Belichtungseinrichtung zur Durchführung des Verfahrens ist angegeben.

FIG.3

EP 0 433 263 A2

# VERFAHREN UND VORRICHTUNG ZUR BELICHTUNG LICHTEMPFINDLICH GEMACHTER SUBSTRATE, INSBESONDERE HALBLEITERSUBSTRATE

Die Erfindung betrifft ein Verfahren zur Belichtung lichtempfindlich gemachter Substrate, insbesondere Halbleitersubstrate gemäß dem Oberbegriff des Patentanspruches 1.

Die Erfindung betrifft ferner eine Vorrichtung zur Durchführung dieses Verfahrens gemäß dem Oberbegriff des Patentanspruches 6.

Verfahren und Belichtungseinrichtungen der gegenständlichen Art werden für Bauelemente und Bausteine der erwähnten Art verwendet. Darunter sind z. B. Platinen, Bildschirme, insbesondere flächige Bildschirme, Mikrochips, wie integrierte Schaltkreise, Module, Rechnerbausteine usw. zu verstehen. Im photolithographischen Verfahren werden Schaltungen bzw. wesentliche Teile davon auf dem mit einer entsprechend aktivierten Oberfläche versehenem Halbleitersubstrat erzeugt. Es können auch Beschichtungen aus Photolacken und ähnlichen Materialien mit Hilfe entsprechender Belichtungseinrichtungen belichtet werden. Für Bausteine der Mikroelektronik werden als Halbleitersubstrat meist dünne Scheiben aus Siliziumkristrallen oder GaAs verwendet. Dabei ist es üblich, auf entsprechend großen Substraten eine Vielzahl gleicher Bausteine bzw. deren Schaltung zu erzeugen und dann die Substrate in die einzelnen Mikrochips zu zerschneiden.

In der vorliegenden Anmeldung werden die für die Herstellung der fertigen Aufnahmen weiterhin benötigten Einrichtungen für die Entwicklung der Aufnahmen und die Bearbeitung der Bauelemente bzw. Bausteine nicht weiter beschrieben, da sie Allgemeingut der Technik sind. Weitere Anwendungsgebiete des gegenständlichen Verfahrens und der zugehörigen Belichtungseinrichtung sind vor allem bei der Herstellung exakter, großflächiger Bildkopien für die verschiedensten Zwecke gegeben.

Eine Belichtung über eine Projektionsoptik wird verwendet, wenn die sonst meist übliche Kontaktkopiatur von der Schablone auf das Substrat nicht eingesetzt werden kann. Der Grund für die Verwendung einer Projektionsoptik ist die Vermeidung von Kontaminationsproblemen, da bei Kontaktkopien immer eine Berührung der Projektionsmaske oder Schablone mit dem Substrat erfolgt, wodurch bei der Serienfertigung Ausbeute und Genauigkeit verschlechtert werden. Für die Übertragung von Strukturen auf Substrate für die Mikroelektronik, sogenannte Wafer, werden beispielsweise sogenannte Stepper verwendet, die das Bild der Projektionsmaske in Einzelschritten entweder im Maßstab 1 : 1 oder in verschiedenen optischen Verkleinerungen übertragen. Dabei kann jeweils der einem Mikrochip zugeordnete Bereich am Wafer in einem Belichtungsvorgang belichtet werden, wonach der Wafer verstellt und in dem dem nächsten Mikrochip zugeordneten Bereich belichtet wird. Die Steppermethode wird auch bei großflächigen Substraten, z. B. bei Flachbildschirmen, verwendet. Besonders bei relativ großflächigen Substraten und Schablonen wird eine Bildübertragung im Projektionsverfahren über eine Optik bevorzugt. Diese Anlagen stellen höchste Anforderungen bei den optischen und mechanischen Parametern. Wie schon erwähnt, ist es bisher üblich, die gesamte Schablone oder Maske auf dem Substrat abzubilden und in einem einzigen Belichtungsvorgang das gesamte Bild zu übertragen. Je größer Schablone und Substrat sind, eine desto größere Optik wird benötigt und desto schwieriger wird es, geeignete Projektionsoptiken und zugehörige Belichtungseinrichtungen zu bauen. Bei einer Welligkeit oder Unebenheit schon wenigstens des Substrates oder der Projektionsmaske kommt es selbst bei hochwertiger Projektionsoptik zu Unschärfen bzw. Änderungen im Übertragungsmaßstab, die für viele Fälle nicht akzeptabel sind. Als Beispiel seien hier Vertiefungen oder Welligkeiten im Glas von Bildschirmen genannt, in deren Bereich die zu übertragenden Strukturen in einem anderen Maßstab oder unscharf gegenüber dem übrigen Bereich abgebildet und damit realisiert werden.

Der nächstliegende Stand der Technik für das erfindungsgemäße Verfahren bzw. die Belichtungseinrichtung gemäß den Oberbegriffen der Patentansprüche 1 und 6 ist durch den Aufsatz "A review of high-resolution microfabrication techniques" Inst. Phys. Conf. Ser. No. 40, 1978, siehe dort insbesondere Seiten 159 und 160 "optical projection" gegeben. Hier wird zur Erzielung einer möglichst gleichmäßigen Belichtung über den ganzen Flächenbereich von Projektionsmaske und Substrat bei im übrigen starrer, ausgerichtet bleibender Zuordnung der Projektionsmaske und des Substrates zu einem aus einem Dachprisma, Linsen und Spiegeln bestehenden Projektionssystem, das im Übertragungsmaßstab 1 : 1 arbeitet, bei der Belichtung eine zeilenweise Abtastbeleuchtung der Projektionsmaske im Durchlichtverfahren vorgenommen und eine Relativverstellung im Sinne des Weiterschiebens der Belichtungszeile über die Projektionsmaske durchgeführt. Dadurch und durch Verwendung eines Projektionssystems, das keine chromatischen Aberrationen aufweist, wird die angestrebte, gleichmäßige Belichtung erzielt. Das Projektionssystem muß sich aber auf jeden Fall zur Erfassung einer gesamten Zeilenlänge eignen, was bedeutet, daß keine Verkleinerung des optischen Projektionssystems gegenüber anderen Verfahren und Belichtungseinrichtungen, bei denen die Belichtung in einem Schritt erfolgt, erzielbar ist. Es gilt also auch hier, daß das Projektionssystem um so größer und aufwendiger wird, je größer Schablone bzw. Maske und Substrat (Wafer) sind.

Bei sich gattungsmäßig von Belichtungseinrichtungen der gegenständlichen Art unterscheidenden Belichtungseinrichtungen, etwa nach der FR-A-1 515 127 und der US-A-3 703 558, ist es bekannt, das Strukturmuster von Bausteinen für die Mikroelektronik nicht in der Gesamtheit zu projizieren, sondern mit Hilfe eines Lichtgriffels auf ein lichtempfindlich gemachtes Substrat zu zeichnen. Dabei wird über eine Projektionseinrichtung ein feiner Lichtstrahl erzeugt und gegen das Substrat gerichtet, das seinerseits auf einem in X- und Y- Richtung verstellbaren Träger ruht. Die Einstellung des Trägers, Unterbrechungen des Lichtstrahles durch einen Verschluß, Modulationen des Lichtstrahles und gegebenenfalls zusätzliche Bewegungen dieses Lichtstrahles - der bei anderen Ausführungen durch einen energiereichen Elektronenstrahl ersetzbar ist - werden, ähnlich wie bei den bekannten computerunterstützten Zeichengeräten über einen Computer nach einem vorgegebenen Programm gesteuert, so daß der Lichtgriffel das Belichtungsmuster auf die lichtempfindliche Oberfläche zeichnet. Es erfolgt keine Bildkopiatur, sondern eine Zeichnung, bei der jeder Bildpunkt durch die Eingabe der X- und Y-Koordinaten und entsprechende Einstellung des Substrates sowie unter Modulation bzw. Unterbrechung des Lichtstrahles angetastet werden muß.

Aufgabe der Erfindung ist die Schaffung eines Verfahrens der eingangs genannten Art, das unter Verwendung einer relativ einfachen Belichtungseinrichtung auch unter an sich schwierigen Bedingungen eine weitgehend exakte Übertragung des durch eine Schablone oder Projektionsmaske vorgegebenen Belichtungsmusters auf das Substrat selbst dann ermöglicht, wenn das Substrat und/oder die Schablone bzw. Belichtungsmaske nicht exakt ebene bzw. planparallele Oberflächen aufweisen und großflächige Bilder oder Strukturen zu übertragen sind. Eine Teilaufgabe der Erfindung besteht in der Schaffung einer zur Durchführung des Verfahrens besonders geeigneten Belichtungseinrichtung.

Die gestellte Aufgabe wird durch die Verfahrensmerkmale des Patentanspruches 1 gelöst. Es können auch mit einer relativ kleinen Projektionsoptik nun großflächige Bildbereiche exakt übertragen werden, wobei wegen der Projektion jeweils nur kleiner Bildbereiche sich bei der Bildprojektion ein fast in den Zylinder übergehender Projektionskegel ergibt, so daß am Substrat scharfkantige Kantenstrukturen erzeugt werden können.

Wenn auch prinzipiell verschiedene Abtastbewegungen z. B. hin- und hergehende Bewegungen der Projektionsoptik bei einem quer dazu erfolgenden Relativvorschub von Substrat und Schablone bzw. Projektionsmaske möglich sind, wird derzeit die Ausgestaltung des Verfahrens gemäß Anspruch 2 bevorzugt. Hier erfolgt wegen der kreisförmigen Bewegung der Übertragungsoptik eine Übertragung in kreisbogenförmigen Zeilen. Die Drehrichtung und die Drehgeschwindigkeit der Projektionsoptik um ihre im Abstand von der Projektionsachse liegende Drehachse können konstant gehalten werden, so daß ein weitgehend erschütterungsfreier Umlauf gewährleistet ist. In der Praxis sind Drehzahlen in der Größenordnung von 1000 U/min durchaus realistisch, so daß bei einem Bildausschnitt in der Größenordnung von 1 mm² und einfacher Belichtung des Substrates theoretisch relative Verstellgeschwindigkeiten der Schablone bzw. Maske gegenüber der Drehachse in der Größenordnung von 1 m/min möglich sind und also auch großflächige Belichtungen in vernünftigen Zeiten durchgeführt werden können.

Vorteilhaft wird die Beleuchtung gemäß Anspruch 3 vorgenommen. Besitzt die Schablone oder Maske einen transparenten oder gleichmäßig lichtdurchlässigen Träger, kann sie im Durchlichtverfahren, also bezogen auf die Projektionsoptik von hinten beleuchet werden. Es ist aber auch eine Beleuchtung im Auflichtverfahren möglich. Nach Varianten kann man mit der Beleuchtungseinrichtung einen den Bildausschnitt enthaltenden größeren Bereich der Maske ausleuchten oder innerhalb des von der Projektionsoptik erfaßbaren Bildausschnittes nur einen noch kleineren Bildbereich beleuchten, so daß dann nur dieser kleinere Bildbereich übertragen wird und das jeweilige Zeilenelement bestimmt.

Zur schnelleren Durchführung eines Belichtungsvorganges kann man das Verfahren in seiner Ausgestaltung nach Anspruch 4 verwenden. Durch die Ausgestaltung des Verfahrens nach Anspruch 5 wird es möglich, durch Unebenheiten, Welligkeiten oder aparallele Anordnung von Projektionsmaske und Substrat hervorgerufene Fehler zu vermeiden.

Eine besonders vorteilhafte Belichtungseinrichtung zur lösung der Teilaufgabe ist im Patentanspruch 6 gekennzeichnet. Diese Belichtungseinrichtung arbeitet zumindest nach dem Verfahren nach den Ansprüchen 1 und 2. Bei dieser Ausführung ergibt sich, da parallele Kreisbogen von gleichem Radius als Zeilen gezeichnet werden, eine geringfügige Änderung des Zeilenabstandes zwischen Mitte und Rand, die aber um so kleiner wird, je größer der Radialabstand der Projektionsoptik von der Drehachse im Verhältnis zur Radiallänge des Belichtungsbereiches (immer bezogen auf die Drehachse) gehalten wird. Durch einstellbare Blenden und ähnliche Maßnahmen kann trotzdem eine gleichmäßige Belichtungsstärke erzielt werden. Man könnte auch die Träger für das Substrat und die Schablone feststehend vorsehen und die Projektionsoptik nach jedem Umlauf oder sogar während des Umlaufes radial verstellen, um den Rillen einer Schallplatte ähnliche Linien in Form einer durchlaufenden Spirale zu zeichnen. Dies setzt allerdings eine besondere Genauigkeit beim Aufbau der Scheibe und bei der Radialführung der Optik voraus.

Für das im Anspruch 3 angegebene Verfahren kann die Belichtungseinrichtung gemäß Anspruch 7 ausgebildet werden. Eine vorteilhafte Weiterbildung zur Durchführung des Verfahrens nach Anspruch 4 entnimmt man dem Anspruch 8.

Zur Durchführung des im Anspruch 5 angegebenen Verfahrensschrittes werden Ausbildungen der Belichtungseinrichtung nach den Ansprüchen 8 und 9 vorgesehen. Dadurch wird erreicht, daß auch bei welligen und unebenen Substraten eine scharfe, maßstabgerechte Bildübertragung stattfindet.

Weitere Einzelheiten und Vorteile des Erfindungsgegenstandes entnimmt man der nachfolgenden Zeichnungsbeschreibung.

In der Zeichnung ist der Erfindungsgegenstand beispielsweise veranschaulicht. Es zeigen

Fig. 1 eine erfindungsgemäße Belichtungseinrichtung schematisch in Seitenansicht,

Fig. 2 eine Draufsicht zu Fig. 1 und

Fig. 3 das Arbeitsschema einer erfindungsgemäßen Einrichtung.

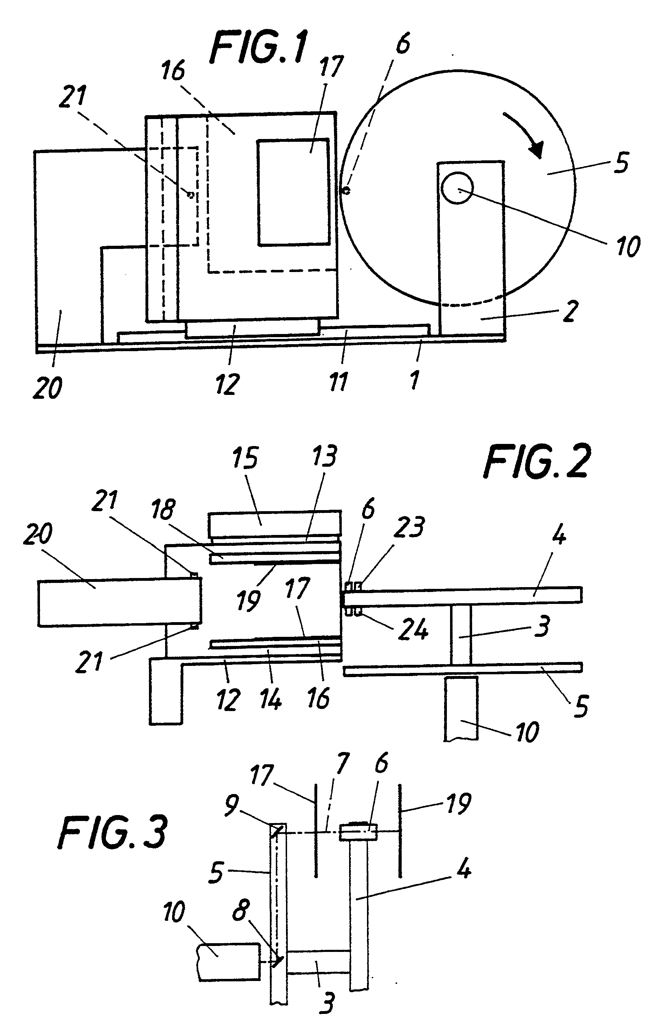

Auf einer nur in Fig. 1 dargestellten Tragplatte 1 ist ein Ständer 2 angebracht, in dem eine Welle 3 lagert, die von einem nicht dargestellten Elektromotor mit einstellbarer, vorzugsweise konstanter Drehzahl antreibbar ist. Auf der Welle 3 sitzen zwei Scheiben 4, 5 von denen die eine (4) mit Abstand von der Welle eine Projektionsoptik 6 trägt, deren Projektionsachse 7 parallel zur Drehachse der Welle verläuft, wobei beim Ausführungsbeispiel eine für die Abbildung im Maßstab 1 : 1 bestimmte Projektionsoptik vorgesehen ist.

Die Scheibe 5 wird synchron mit der Scheibe 4 angetrieben und enthält zwei als Spiegel 8, 9 dargestellte optische Leiteinrichtungen für einen von einem Laser 10 ausgesandten Lichtstrahl, der koaxial zur Drehachse der Welle 3 auf den in der Scheibe 5 untergebrachten Spiegel 8 trifft und vom Spiegel 9 in die Projektionsachse 7 der Projektionsoptik 6 projiziert wird. Der am Spiegel 9 austretende Lichtstrahl läuft also auf der Projektionsachse 7 um die Welle 3 rotierend um und wird von der Projektionsoptik 6 erfaßt und weiter projiziert. Die Scheibe 5 dient nur als Trageinrichtung für die optischen Leiteinrichtungen 8, 9. Die Ausbildung als Scheibe ist vorgesehen, um, ebenso wie bei der Scheibe 4, ein ausgewuchtetes mit der Welle 3 umlaufendes System zu erhalten.

Auf der Grundplatte 1 sind Schiebeführungen 11 angebracht, auf denen zwei miteinander vorzugsweise gekuppelte Schlitten 12, 13 senkrecht zur Drehachse der Welle 3 verschiebbar sind. Diese Schlitten 12, 13 halten über Justiereinrichtungen 14, 15 einen Träger 16 für eine Projektionsmaske oder Schablone 17 und einen weiteren Träger 18 für ein Substrat 19. Mit Hilfe der Justiereinrichtung 14 kann der Träger 16 in Z-Richtung verstellt werden, wogegen die Justiereinrichtung 15 eine Einstellung des Substrates 19 in X-, Y- und Z- Richtung sowie eine Drehverstellung des Substrates 19 zuläßt. Mit Hilfe der Justiereinrichtungen ist es möglich, das Substrat 19 und die Projektionsmaske exakt gegeneinander und für sich oder gemeinsam relativ zur Scheibe 4 auszurichten. Für die Erst justierung ist an einem Träger 20 eine optische Meßeinrichtung 21, 22 vorgesehen, mit deren Hilfe zunächst Substrat 19 und Schablone 17 ausgerichtet werden. Aus der in den Fig. 1 und 2 dargestellten Lage können die Träger 12, 13 senkrecht zur Drehachse der Welle 3 verstellt werden, so daß die Projektionsoptik 6 zwischen Substrat 19 und Projektionsmaske eintritt und den jeweils vom Lichtstrahl beleuchteten Bildpunkt der Projektionsmaske 17 auf der Oberfläche des Substrates 19 abbildet, so daß dann, wenn Substrat 19 und Schablone 17 radial über die Länge des Belichtungsbereiches verstellt sind, die Schablone 17 vollständig in kreisbogenförmigen Zeilen am Substrat 19 abgebildet ist. Abstandssensoren 23, 24 neben der Projektionsoptik messen laufend die momentanen Projektionsabstände und steuern über eine nicht dargestellte Steuereinrichtung die Feintriebe 14, 15 im Sinne einer Konstanthaltung des Verhältnisses dieser Projektionsabstände.

Beim Ausführungsbeispiel wird die Projektionsmaske 17 durch das von der Beleuchtungseinheit 10 abgestrahlte Licht durchstrahlt und über die Projektionsoptik 6 auf das Substrat abgebildet.

## Ansprüche

1. Verfahren zur Belichtung lichtempfindlich gemachter Substrate, insbesondere Halbleitersubstrate, bei der Herstellung elektronischer Bauelemente und Bausteine auf photolithographischem Wege, bei dem eine ein Belichtungsmuster bestimmende Schablone (17) oder Maske über eine Beleuchtungseinrichtung (8-10) beleuchtet und das von dieser Schablone bzw. Maske bestimmte Belichtungsmuster über eine Projektionsoptik (6) in einander ergänzenden, nacheinander projizierten Bildteilen auf ein auf einem Substratträger (18) gehaltenes, lichtempfindlich gemachtes Substrat (19) übertragen wird, dadurch gekennzeichnet, daß eine Projektionsoptik (6) verwendet wird, die nur einen kleinen, insbesondere nahezu punktförmigen Bildausschnitt der über die Beleuchtungseinrichtung (8-10) beleuchteten Schablone (17) bzw. Maske erfaßt und auf die zugeordnete Stelle des am Substratträger (18) gehaltenen Substrates (19) überträgt und daß die Belichtung des Substrates unter Erzeugung einer eine zeilenweise Abtastung ergebenden Relativbewegung zwischen der Projektionsoptik (6), der Schablone (17) bzw. Maske und dem Substrat (19) vorgenommen

2. Verfahren nach Anspruch 1, dadurch gekennzeichnet, daß die Projektionsoptik (6) zwischen Schablone (17) bzw. Projektionsmaske und Substrat (19) mit der Projektionsachse (7) normal zu den Parallelebenen von Substrat (19) und Schablone (17) bzw. Maske ausgerichtet und um eine parallel zur Projektionsachse (7) verlaufende Achse (3) rotierend angetrieben wird und Schablone (17) bzw. Maske und Substrat (19) gemeinsam parallel zueinander unter Änderung des Abstandes von der Drehachse (3) verschoben werden, so daß die Projektionsoptik (6) das Belichtungsmuster der Schablone (17) bzw. Projektionsmaske in kreisbogenförmigen, aus den von der Projektionsoptik (6) erfaßten Bildausschnitten gebildeten, gegebenenfalls ineinandergreifenden Zeilen am Substrat (19) abbildet.

3. Verfahren nach Anspruch 1 oder 2, dadurch gekennzeichnet, daß mit der Beleuchtungseinrichtung (8-10) jeweils nur der von der Projektionsoptik (6) erfaßte Bildausschnitt der Schablone (17) bzw. Projektionsmaske beleuchtet wird.

4. Verfahren nach einem der Ansprüche 1 bis 3, dadurch gekennzeichnet, daß mehrere gemeinsam antreibbare Projektionsoptiken (6) mit zugehörigen Beleuchtungseinrichtungen (8-10) verwendet werden.

5. Verfahren nach einem der Ansprüche 1 bis 5, dadurch gekennzeichnet, daß während der Projektion die Projektionsabstände von Schablone (17) bzw. Projektionsmaske, Projektionsoptik (6) und Substrat (19) laufend überwacht und auf ein konstantes Verhältnis der momentanen Projektionsabstände eingestellt werden.

6. Belichtungseinrichtung zur Durchführung des Verfahrens nach einem der Ansprüche 1 bis 5, bestehend aus einer ein Belichtungsmuster bestimmenden Schablone (17) oder Maske, einer Beleuchtungseinrichtung für die Schablone oder Maske, einem Substratträger (18) und einer Projektionsoptik, (6) die das Belichtungsmuster der Schablone (17) oder Projektionsmaske in einander ergänzenden nacheinander projizierten Bildteilen auf ein am Substratträger (18) gehaltenes, lichtempfindlich gemachtes Substrat (19) überträgt, dadurch gekennzeichnet, daß eine für die Erfassung und Projektion nur eines kleinen, insbesondere nahezu punktförmigen Bildausschnittes der über die Beleuchtungseinrichtung (8-10) beleuchteten Schablone (17) auf eine zugeordnete Stelle des am Substratträger gehaltenen Substrates (19) überträgt, ausgebildete Projektionsoptik (6) vorgesehen ist, daß die Projektionsoptik (6) um eine zu der auf das Substrat (19) gerichteten Projektionsachse (7) parallele Achse (3) rotierend antreibbar ist und daß die Schablone bzw. Maske (17) und der Substratträger (18) quer zur Projektionsachse (7) relativ zur Projektionsoptik (6) verschiebbar sind, so daß diese das Belichtungsmuster der Schablone bzw. Maske (17) in kreisbogenförmigen, aus den von der Projektionsoptik (6) nacheinander erfaßten Bildausschnitten gebildeten, gegebenenfalls ineinandergreifenden Zeilen am Substrat (19) abbildet.

7. Belichtungseinrichtung nach Anspruch 6, dadurch gekennzeichnet, daß als Beleuchtungseinrichtung eine ein Lichtstrahlenbündel erzeugende Lichtquelle, insbesondere ein Laser (10) vorgesehen ist und daß das Lichtstrahlenbündel über mit der Projektionsoptik (6) umlaufende Leiteinrichtungen (8, 9) den jeweils von der Projektionsoptik (6) erfaßten Bildausschnitt der Projektionsmaske (17) oder Schablone beleuchtet.

8. Belichtungseinrichtung nach den Ansprüchen 6 und 7, dadurch gekennzeichnet, daß eine oder mehrere parallele Projektionsoptiken (6) mit Radialabstand von der zu ihrer Projektionsachse parallelen Drehachse (3) an einer rotierend antreibbaren Scheibe (4) befestigt ist bzw. sind, daß der Substratträger (18) sowie ein Träger für die Schablone (17) oder Projektionsmaske das Substrat (19) sowie die Schablone (17) bzw. Projektionsmaske in zur Scheibe (4) im wesentlichen parallelen Ebenen mit Abstand von den beiden Seiten der Scheibe (4) halten und über Stelltriebe (14, 15) normal zu der bzw. den Projektionsachsen (7) über die Radiallänge des Belichtungsbereiches verstellbar sind.

9. Belichtungseinrichtung nach einem der Ansprüche 6 bis 8, dadurch gekennzeichnet, daß Feintriebe (14, 15) zur Ausrichtung des Substratträgers (18) mit dem Substrat (19) und/oder der Projektionsmaske (17) bzw. Schablone gegenüber ihren Trägern (12, 13) vorgesehen sind.

10. Belichtungseinrichtung nach Anspruch 9, dadurch gekennzeichnet, daß eine Steuereinrichtung für die Feintriebe (14, 15) mit mit der Projektionsoptik (6) umlaufenden Distanzfühlern (23, 24) zur Messung des momentanen Projektionsabstandes zwischen der Maske (17) und der Projektionsoptik (6) bzw. der Substratoberfläche und der Projektionsoptik verbunden ist, so daß sie über die Feintriebe ein konstantes Verhältnis, insbesondere ein Verhältnis von 1 : 1 der Projektionsabstände einstellt.

11. Bauelemente und Bausteine, die aus lichtempfindlich gemachten Substraten unter Belichtung nach dem Verfahren nach einem der Ansprüche 1 bis 5 hergestellt sind.

EP 0 433 263 A2

FIG.1

FIG.2

FIG.3